(19)

**Europäisches Patentamt**
**European Patent Office**
**Office européen des brevets**

(11) **EP 4 484 619 A1**

(12) **EUROPEAN PATENT APPLICATION**
published in accordance with Art. 153(4) EPC

(43) Date of publication:
01.01.2025 Bulletin 2025/01

(21) Application number: 23759937.8

(22) Date of filing: 20.02.2023

(51) International Patent Classification (IPC):
*C30B 29/38* (2006.01)   *C30B 17/00* (2006.01)
*C30B 19/02* (2006.01)

(52) Cooperative Patent Classification (CPC):
C30B 17/00; C30B 19/02; C30B 29/38

(86) International application number:
PCT/JP2023/006081

(87) International publication number:
WO 2023/162936 (31.08.2023 Gazette 2023/35)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 24.02.2022 JP 2022027230
17.02.2023 JP 2023023802

(71) Applicants:
• Tohoku University
Sendai-shi, Miyagi 980-8577 (JP)
• Dowa Holdings Co., Ltd.
Tokyo 101-0021 (JP)

(72) Inventors:
• FUKUYAMA, Hiroyuki
Sendai-shi, Miyagi 980-8577 (JP)
• OHTSUKA, Makoto
Sendai-shi, Miyagi 980-8577 (JP)
• ADACHI, Masayoshi
Sendai-shi, Miyagi 980-8577 (JP)
• MIYATA, Rintaro
Sendai-shi, Miyagi 980-8577 (JP)
• WATANABE, Yasuhiro
Tokyo 101-0021 (JP)

(74) Representative: Müller-Boré & Partner
Patentanwälte PartG mbB
Friedenheimer Brücke 21
80639 München (DE)

(54) **METHOD FOR PRODUCING ALN SINGLE CRYSTALS, ALN SINGLE CRYSTALS, AND DEVICE FOR PRODUCING ALN SINGLE CRYSTALS**

(57)     Provided are a method of producing single crystal AlN, single crystal AlN, and a single crystal AlN production apparatus with which single crystal AlN can be cheaply and continuously produced. The method of producing single crystal AlN includes a melt formation step of heating and melting an alloy containing Al to form a melt of the alloy and a deposition step of cooling a portion of the melt and providing a temperature gradient in the melt while causing deposition of single crystal AlN. In the deposition step, a nitrogen-containing gas is brought into contact with a high-temperature portion of the melt and a single crystal AlN seed crystal or a substrate for crystal growth is held in a low-temperature portion of the melt so as to continue to take nitrogen into the melt in the high-temperature portion while causing deposition of single crystal AlN on the AlN seed crystal or substrate and continuous growth of single crystal AlN in the low-temperature portion.

*FIG. 1*

EP 4 484 619 A1

## Description

TECHNICAL FIELD

The present disclosure relates to a method of producing single crystal AlN, single crystal AlN, and a single crystal AlN production apparatus.

BACKGROUND

Ultraviolet light-emitting elements are next generation light sources that are expected to be used in a wide range of applications such as sterilization light sources, high luminance white light sources combined with phosphors, high density data recording light sources, and resin curing light sources. These ultraviolet light-emitting elements are formed from AlGaN-based nitride semiconductors.

Candidates for use as substrate materials for these AlGaN-based nitride semiconductors include SiC, GaN, and AlN (aluminum nitride) due to their high degree of lattice matching with AlGaN. However, SiC and GaN absorb light of higher energy than wavelengths of 380 nm and 365 nm, respectively, and thus limit the wavelength region where light can be extracted. In contrast, AlN has a wider band gap than AlGaN, does not result in wavelength region limitation like that with SiC or GaN, and is, therefore, considered to be the most outstanding substrate material. However, AlN displays high dissociation pressure at high temperature, and thus does not adopt a molten state under normal pressure. For this reason, it is exceedingly difficult to produce single crystal AlN from a melt of AlN itself in the same manner as single crystal silicon.

Attempts have previously been made to produce single crystal AlN by production methods such as hydride vapor phase epitaxy (HVPE), liquid phase epitaxy, and sublimation. For example, a method in which a substrate is brought into contact with a melt containing a group III element and an alkali metal under high pressure to cause growth of group III nitride crystals (for example, refer to Patent Literature (PTL) 1) and a method in which nitrogen atom-containing ammonia gas is injected into a melt of a group III metal element and in which group III nitride microcrystals are produced in the melt of the group III element (for example, refer to PTL 2) have been proposed. However, with these methods of producing single crystal AlN, it has been necessary to adopt a high pressure or high temperature and it has been difficult to produce crystals that are practicable with regard to size, quality, and cost.

In order to solve this problem, the inventors have been developing, as a method of obtaining cheap and good quality single crystal AlN at low temperature and normal pressure, a liquid phase epitaxy method for single crystal AlN in which a gas containing nitrogen is brought into contact with the surface of a melt of an alloy containing Al so as to cause crystal growth at the surface of the melt (for example, refer to PTL 3).

CITATION LIST

Patent Literature

    PTL 1: JP2004-224600A
    PTL 2: JP-H11-189498A
    PTL 3: JP2019-194133A

SUMMARY

(Technical Problem)

Although the liquid phase epitaxy method for single crystal AlN described in PTL 3 enables cheap production of single crystal AlN that is of extremely good quality, the surface of the melt becomes covered as crystal growth proceeds, which blocks the supply of nitrogen from the liquid surface where the single crystal AlN has been formed. Consequently, there is room for improvement in terms of growth rate. PTL 3 proposes a configuration in which localized heating is performed using a heating laser separately to melt formation in order to continue supplying nitrogen from the melt surface. However, were it possible to continuously grow single crystal AlN at a location other than at the surface of the melt, this would enable stable and continuous growth of single crystal AlN. In particular, were it possible to continuously supply nitrogen from the surface of the melt without additional heating other than in melt formation, it is expected that growth of single crystal AlN could be achieved with even better energy efficiency.

The present disclosure is made focusing on issues such as set forth above, and an object thereof is to provide a method of producing single crystal AlN, single crystal AlN, and a single crystal AlN production apparatus with which single crystal AlN can be cheaply and continuously produced.

(Solution to Problem)

In order to achieve this object, a method of producing single crystal AlN according to the present disclosure involves cooling a portion of a melt of an alloy containing Al so as to provide a temperature gradient in the melt. This method also involves continuing to take nitrogen into the melt in a high-temperature portion of the melt while causing deposition of single crystal AlN on an AlN seed crystal or a substrate for crystal growth (hereinafter, also referred to simply as a "growth substrate") and continuous growth of the single crystal AlN in a low-temperature portion of the melt. Specifically, primary features of the present disclosure are as follows.

(1) A method of producing single crystal AlN comprising: a melt formation step of heating and melting an alloy containing Al to form a melt of the alloy; and a deposition step of cooling a portion of the melt and providing a temperature gradient in the melt while causing deposition of single crystal AlN, wherein in the deposition step, a nitrogen-containing gas is brought into contact with a high-temperature portion of the melt and a single crystal AlN seed crystal or a substrate for crystal growth is held in a low-temperature portion of the melt so as to continue to take nitrogen into the melt in the high-temperature portion while causing deposition of the single crystal AlN on the AlN seed crystal or the substrate and continuous growth of the single crystal AlN in the low-temperature portion.

(2) The method of producing single crystal AlN according to the foregoing (1), wherein the nitrogen-containing gas includes $N_2$ gas, and when activity of Al in the melt when a reaction for formation of the single crystal AlN expressed by formula (A), shown below:

$$2Al\ (l) + N_2\ (g) \rightarrow 2AlN\ (s) \qquad (A)$$

is at equilibrium is taken to be $a^{eq}_{.Al}$, an equilibrium constant of formula (A) is taken to be K, the Boltzmann constant is taken to be k, absolute temperature is taken to be T, and partial pressure of $N_2$ of the nitrogen-containing gas during deposition is taken to be pNz, and when a temperature at which driving force $\Delta\mu$ of growth of the single crystal AlN expressed by formula (B), shown below:

[Math. 1]

$$\Delta\mu = kT\left(\ln P_{N2} + \ln K + \ln a^{eq\,2}_{Al}\right) \qquad (B)$$

has a value of 0 is taken to be $T_0$, a temperature of the high-temperature portion is set as higher than $T_0$ and a temperature of the low-temperature portion is set as not lower than a temperature of a liquidus of the alloy and lower than $T_0$.

(3) The method of producing single crystal AlN according to the foregoing (2), wherein the melt formation step includes a high-temperature heating step of heating the high-temperature portion to a temperature of $T_0+30$ K or higher.

(4) The method of producing single crystal AlN according to the foregoing (3), wherein the melt formation step includes a low-temperature heating step of, after the high-temperature heating step, heating the high-temperature portion to a temperature of higher than $T_0$ and lower than $T_0+30$ K.

(5) The method of producing single crystal AlN according to any one of the foregoing (1) to (4), wherein a holder that holds the single crystal AlN seed crystal or the substrate for crystal growth includes a cooling mechanism, and the temperature gradient is provided in the melt by bringing the holder into contact with the melt in the deposition step.

(6) The method of producing single crystal AlN according to any one of the foregoing (1) to (5), wherein the substrate for crystal growth is an AlN template substrate having single crystal AlN epitaxially grown on single crystal sapphire.

(7) The method of producing single crystal AlN according to the foregoing (6), wherein the AlN template substrate is an AlN template substate having C-plane single crystal AlN epitaxially grown on C-plane single crystal sapphire, and an X-ray rocking curve for (10-12) planes of the C-plane single crystal AlN has a full width at half maximum of 300 arcsec or less.

(8) The method of producing single crystal AlN according to any one of the foregoing (1) to (7), wherein the alloy containing Al is a Ni-Al alloy.

(9) Single crystal AlN formed on a single crystal AlN seed crystal or a substrate for crystal growth and comprising $8 \times 10^{16}/cm^3$ to $1 \times 10^{21}/cm^3$ of one or more of Fe, Ni, Cu, and Co as impurities.

(10) Single crystal AlN formed on a single crystal AlN seed crystal or a substrate for crystal growth and comprising $8 \times 10^{16}/cm^3$ to $1 \times 10^{21}/cm^3$ of Ni as an impurity.

(11) The single crystal AlN according to the foregoing (9) or (10), having a carbon concentration of $2 \times 10^{17}\ cm^{-3}$ or

less.

(12) A single crystal AlN production apparatus comprising: a reaction vessel having an inner part that can be supplied with a nitrogen-containing gas; a crucible that can hold a melt of an alloy containing Al; a heating device for the melt; and a holder for an AlN seed crystal or a growth substrate, wherein the holder includes a lifting and lowering mechanism and a cooling mechanism, and a temperature gradient can be provided between the melt and the growth substrate by bringing the holder into contact with the melt.

(Advantageous Effect)

According to the present disclosure, it is possible to provide a method of producing single crystal AlN, single crystal AlN, and a single crystal AlN production apparatus with which single crystal AlN can be cheaply and continuously produced.

BRIEF DESCRIPTION OF THE DRAWINGS

In the accompanying drawings:

FIG. 1 is a schematic view illustrating an overview of a single crystal AlN growth apparatus related to a method of producing single crystal AlN of an embodiment of the present disclosure;

FIG. 2 is a graph illustrating a relationship between driving force $\Delta\mu$ of growth of single crystal AlN and temperature (T) for each composition of Ni-Al alloy;

FIG. 3 is a front view illustrating one form of overall configuration of a single crystal AlN growth apparatus related to a method of producing single crystal AlN of an embodiment of the present disclosure;

FIG. 4 is a front view illustrating another form of overall configuration of a single crystal AlN growth apparatus related to a method of producing single crystal AlN of an embodiment of the present disclosure;

FIG. 5 is a front view illustrating another form of overall configuration of a single crystal AlN growth apparatus related to a method of producing single crystal AlN of an embodiment of the present disclosure;

FIG. 6 is a cross-sectional SEM image of an AlN template substrate used as a substrate for crystal growth in Examples 1 to 5;

FIG. 7 is a cross-sectional SEM image of an AlN template substrate after single crystal AlN growth in Example 1;

FIG. 8 is an SEM-EDX profile for a single crystal portion grown on an AlN template substrate after single crystal AlN growth in Example 1;

FIG. 9 is a cross-sectional SEM image of an AlN template substrate after single crystal AlN growth in Example 2;

FIG. 10 is a cross-sectional SEM image of an AlN template substrate after single crystal AlN growth in Example 3;

FIG. 11 is a cross-sectional SEM image of an AlN template substrate after single crystal AlN growth in Example 4;

FIG. 12A presents SIMS measurement results for N (nitrogen) and Ni (nickel) in single crystal AlN on an AlN template in Example 2; and

FIG. 12B presents SIMS measurement results for O (oxygen) and C (carbon) in single crystal AlN on an AlN template in Example 2.

DETAILED DESCRIPTION

The following describes an embodiment of the present disclosure with reference to the drawings. Note that when referring simply to "nitrogen" in the present specification, this means both $N_2$ and N.

(Method of producing single crystal AlN)

A method of producing single crystal AlN according to the present embodiment includes a melt formation step of heating and melting an alloy containing Al to form a melt of the alloy and a deposition step of cooling a portion of the melt and providing a temperature gradient in the melt while causing deposition of single crystal AlN. In the deposition step of this production method, a nitrogen-containing gas is brought into contact with a high-temperature portion of the melt and a growth substrate is held in a low-temperature portion of the melt so as to continue to take nitrogen into the melt in the high-temperature portion while causing deposition of single crystal AlN on the growth substrate and continuous growth of the single crystal AlN in the low-temperature portion.

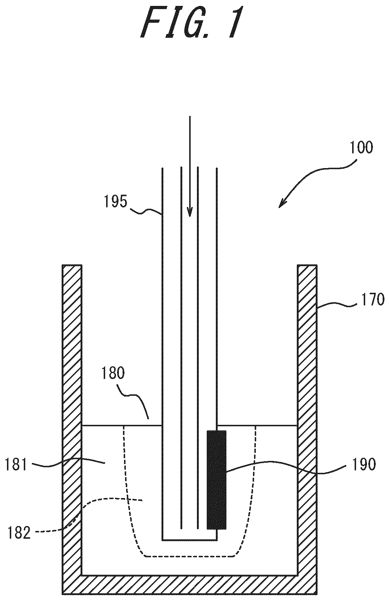

Prior to describing each of the steps in detail, the following describes a single crystal AlN production apparatus 100, schematically illustrated in FIG. 1, that can be adopted in the method according to the present disclosure. A crucible 170 of this single crystal AlN production apparatus 100 is set in a nitrogen-containing gas. The inside of this crucible 170 can be replenished with an alloy containing Al. Heating of this alloy yields a melt 180. A holder 195 that holds a growth substrate 190 can be immersed in the melt 180.

By providing the holder 195 holding the growth substrate 190 with a double tube structure or the like, it is possible to provide a cooling mechanism where a cooling gas or cooling liquid can be fed into an inner tube thereof, and thus it is possible to cool a portion of the melt 180 using this cooling substance. This makes it possible to provide a temperature gradient in the melt 180 and thereby form a high-temperature portion 181 and a low-temperature portion 182. By using this single crystal AlN production apparatus 100, it is possible to continue to bring a nitrogen-containing gas into contact with the high-temperature portion 181 of the melt 180 while, on the other hand, immersing the holder 195 holding the growth substrate 190 in the low-temperature portion 182 of the melt 180. Note that the "nitrogen-containing gas" may include nitrogen gas ($N_2$ gas) or another nitrogen atom-containing gas (for example, ammonia gas) so long as it is a gas that can serve as a supply source of nitrogen to the melt 180. The following provides a detailed description of the growth substrate and each step, in order, while continuing to refer to FIG. 1.

<Growth substrate>

The growth substrate 190 is a substrate that enables growth of single crystal AlN at the surface thereof and preferably has single crystal AlN at the substrate surface. In particular, it is preferable to use an AlN template substrate that has single crystal AlN epitaxially grown on a sapphire substrate. Single crystal AlN itself (single crystal AlN seed crystal) may be used as the growth substrate 190 instead of a substrate for crystal growth. In FIG. 1, a substrate form is illustrated.

It is preferable that an AlN template substrate having C-plane single crystal AlN epitaxially growth on C-plane single crystal sapphire is used as the AlN template substrate, and it is also preferable that an X-ray rocking curve for (10-12) planes of the C-plane single crystal AlN has a full width at half maximum of 300 arcsec or less. In addition, it is more preferable that the film thickness of the C-plane single crystal AlN on the C-plane single crystal sapphire is not less than 0.3 μm and not more than 1.2 μm, and it is also more preferable that an X-ray rocking curve for (0002) planes of the C-plane single crystal AlN has a full width at half maximum of 150 arcsec or less.

By using an AlN template substrate for which the full width at half maximum of an X-ray rocking curve for (10-12) planes of C-plane single crystal AlN grown on C-plane single crystal sapphire is 300 arcsec or less, it is possible to improve the crystal quality of single crystal AlN that is produced by the production method according to the present disclosure. Moreover, it is also possible to inhibit decomposition and loss of the single crystal AlN at the surface of the AlN template substrate due to etching when the AlN template substrate is immersed in the melt and liquid phase growth of AlN is performed. In a case in which the AlN that comes into contact with the melt 180 is polycrystalline or a case in which the AlN is a single crystal but in which an X-ray rocking curve for (10-12) planes has a full width at half maximum of more than 300 arcsec, the AlN crystal readily undergoes decomposition and may disappear upon immersion in the melt 180. Even in a situation in which a single crystal AlN seed crystal is used, it is preferable that the quality thereof is of a level such that the full width at half maximum of an X-ray rocking curve for (10-12) planes of the single crystal AlN is 300 arcsec or less for the same reason.

In the sapphire substrate used in the AlN template substrate, the C-plane is preferably a plane that is inclined with an off-angle of not less than 0.05° and not more than 0.55°. C-plane single crystal SiC can also be used instead of sapphire.

The AlN template substrate that has C-plane single crystal AlN epitaxially grown on C-plane single crystal sapphire and that results in an X-ray rocking curve for (10-12) planes of the single crystal AlN having a full width at half maximum of 300 arcsec or less can be produced by subjecting an AlN template substrate obtained through growth by MOCVD to annealing at 1823 K or higher (for example, 1873 K) in a nitrogen atmosphere so as to perform dislocation reduction treatment.

Note that the method of growth of AlN is preferably MOCVD in which trimethylaluminum (TMA) and ammonia are used as source gases, though HVPE or sputtering can alternatively be used.

<Melt formation step>

In the melt formation step, an alloy containing Al is heated and melted to form a melt 180 of the alloy. Although no specific limitations are placed on the composition of the alloy that forms the melt 180, it is preferable that the alloy has Al and a metal element that has a lower tendency than Al to form a nitride as main components, and it is also preferable that the liquidus temperature for the alloy is lower than a temperature at which AlN undergoes thermodynamic decomposition. With regard to alloy components other than Al, it is preferable that the alloy contains at least one element among Fe, Ni, Cu, Co, and Si as a main component. By using a melt 180 of such an alloy, it is possible to efficiently produce single crystal AlN. In particular, the use of a Ni-Al alloy is most preferable. Of such alloys, it is preferable to adopt an alloy composition that results in a temperature ($T_0$) at which driving force $\Delta\mu$ of growth of the single crystal AlN has a value of zero (described further below) being not lower than 1700 K and not higher than 2100 K, and more preferable to adopt an alloy composition that results in the temperature ($T_0$) being not lower than 1750 K and not higher than 2000 K. The Al composition in the Ni-Al alloy is preferably not less than 15 mol% and not more than 35 mol%. Note that from a viewpoint of apparatus preservation, it is preferable that a strongly corrosive element such as Ga is not used as a constituent element of the alloy melt 180.

The material of the crucible 170 that accommodates the melt 180 may be any type of material. It is preferable that a sinter containing nitrogen is used as the crucible 170 itself or is provided at an inner surface of the crucible 170. Moreover, the sinter containing nitrogen is preferably produced from AlN or a material that is more thermodynamically unstable than AlN. By using AlN or a material that is more thermodynamically unstable than AlN as the crucible 170 that accommodates the alloy melt 180 or as an inner surface of the crucible 170, it is possible for the sinter itself to serve as a supply source of nitrogen (nitrogen and Al in the case of AlN) into the melt 180. Moreover, it is also preferable for the crucible 170 to be made of CSZ or BN. In a case in which the crucible 170 is made of CSZ or BN, addition of a material containing Al such as a sintered AlN piece or a polycrystalline AlN may be separately performed so as to replenish the amount of Al in the melt 180 that decreases in accompaniment to crystal growth.

<Deposition step>

In the deposition step, a portion of the melt 180 is cooled and a temperature gradient is provided in the melt 180 while causing deposition of single crystal AlN after the above-described melt formation step. Moreover, in this deposition step, a nitrogen-containing gas is brought into contact with a high-temperature portion 181 of the melt 180 and the growth substrate 190 is held in a low-temperature portion 182 of the melt 180 by the holder 195. Through the above, nitrogen continues to be taken into the melt 180 in the high-temperature portion 181 while also causing deposition of AlN and continuous growth of single crystal AlN on the growth substrate 190 in the low-temperature portion 182. In other words, by transporting nitrogen that has dissolved in the alloy melt 180 to the low-temperature portion 182 of the alloy melt 180 and by causing this nitrogen to react with Al in the melt 180 at the surface of the growth substrate 190 that is held in the low-temperature portion 182, it is possible to cause continuous growth of single crystal AlN. In the method according to the present disclosure, the melt formation step and the deposition step can be performed in parallel in this manner while simultaneously implementing both supply of nitrogen into the alloy melt 180 and deposition of AlN through reaction of dissolved nitrogen and Al in the alloy, thereby enabling continuous growth of single crystal AlN. During the above, it is preferable that the high-temperature portion 181 is maintained in a temperature range in which AlN is thermodynamically unstable (i.e., a temperature range in which AlN decomposes without being deposited) while cooling the low-temperature portion 182 to a temperature at which AlN is thermodynamically stable.

<Driving force $\Delta\mu$ of growth of single crystal AlN>

The following describes driving force $\Delta\mu$ of growth of single crystal AlN and also describes a more preferable form of the present embodiment. In the method of producing single crystal AlN according to the present disclosure, Al in the melt 180 and nitrogen supplied into the melt 180 react to form the single crystal AlN. In a case in which the nitrogen-containing gas serving as the nitrogen supply source includes $N_2$ gas, the reaction at this time is indicated by the following formula (1).

$$2Al\ (l) + N_2\ (g) \rightarrow 2AlN\ (s) \qquad (1)$$

When the activity of AlN, the activity of Al in the melt 180, and the partial pressure of $N_2$ when the reaction of formula (1) is at equilibrium are taken to be $a^{eq}_{.AlN}$, $a^{eq}_{.Al}$, and $P^{eq}.N_2$, respectively, the equilibrium constant K of formula (1) is expressed by the following formula (2).
[Math. 2]

$$K = \frac{a^{eq\ 2}_{AlN}}{a^{eq\ 2}_{Al}\ P^{eq}_{N_2}} \qquad (2)$$

Since AlN is a substantially pure solid, the activity $a^{eq}_{.AlN}$ of AlN is taken to be 1. Moreover, when the partial pressure of $N_2$ in the atmosphere is taken to be $PN_2$, the driving force $\Delta\mu$ of growth of single crystal AlN is given by the difference between the chemical potential of $N_2$ in the atmosphere and the chemical potential of $N_2$ when formula (1) is at equilibrium and is expressed by the following formula (3). Furthermore, by using the equilibrium relationship of formula (2), it is possible to finally express the driving force $\Delta\mu$ of growth of single crystal AlN by the following formula (4). In formulae (3) and (4), k represents the Boltzmann constant and T represents the absolute temperature.

[Math. 3]

$$\Delta\mu = kT\left(\ln P_{N2} - \ln P_{N2}^{eq}\right) \qquad (3)$$

$$\Delta\mu = kT\left(\ln P_{N2} + \ln K + \ln a_{Al}^{eq\,2}\right) \qquad (4)$$

It can be seen from formula (4) that the driving force $\Delta\mu$ of growth of single crystal AlN in the melt 180 is expressed by the partial pressure $P_{N2}$ of $N_2$ in the atmosphere, the equilibrium constant K, the Boltzmann constant k, the absolute temperature T, and the activity $a^{eq}_{Al}$ of Al in the melt 180. Accordingly, it is possible to control the driving force $\Delta\mu$ of growth of single crystal AlN in the melt 180 through the partial pressure of $N_2$ in the atmosphere, the temperature, and the alloy composition of the melt 180. The temperature at which the driving force $\Delta\mu$ of growth of single crystal AlN has a value of zero is taken to be $T_0$. In this case, the temperature of the high-temperature portion 181 of the melt 180 (hereinafter, denoted as T1) is preferably higher than $T_0$, and the temperature of the low-temperature portion 182 (hereinafter, denoted as T2) is preferably not lower than the temperature of a liquidus for the alloy forming the melt 180 and lower than $T_0$. By maintaining the temperature T1 of the high-temperature portion 181 of the melt 180 at a temperature where $\Delta\mu$ is negative (i.e., T1 > $T_0$) while also bringing $N_2$ gas into contact with this high-temperature portion 181, it is possible to cause more reliable dissolution of nitrogen into the melt 180. Moreover, since a greater amount of nitrogen can be caused to dissolve in the alloy melt 180 when the alloy melt is at a higher temperature, it is preferable that the melt formation step includes a high-temperature heating step of heating the high-temperature portion 181 to a temperature of $T_0$+30 K or higher.

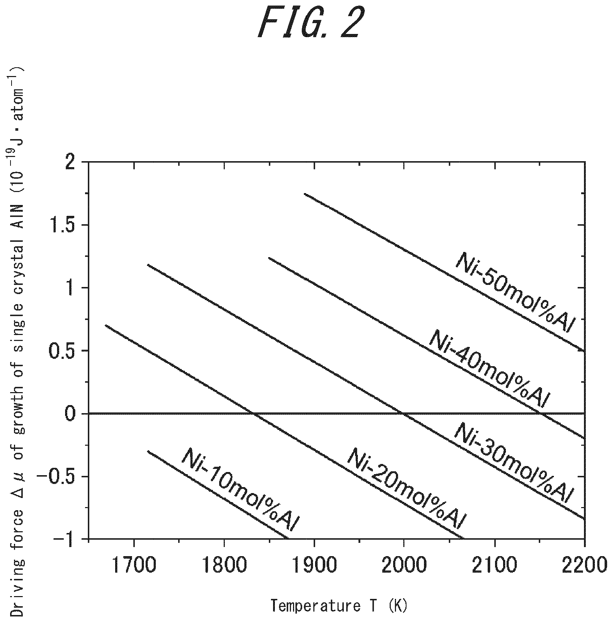

The following describes, as an example, a case in which the melt 180 is obtained from a Ni-Al alloy containing Al and Ni as main components. With regard to the activity $a^{eq}_{Al}$ of Al in the melt 180, the composition dependence of the activity of Al in Ni-Al at a temperature of 1873 K is reported in "Desai PD. Thermodynamic properties of selected binary aluminum alloy systems. J Phys Chem Ref data. 1987; 16: 109-24.", and data for this composition dependence can be used. Moreover, the activity of Al in Ni-Al at temperatures other than 1873 K can be determined by taking Ni-Al to be a regular solution. When the partial pressure $P_{N2}$ of $N_2$ in the atmosphere is taken to be 1 bar, a relationship between the driving force $\Delta\mu$ of growth of single crystal AlN and the temperature (T) at each composition of Ni-Al alloy can be determined from formula (4). The relationship at each alloy composition determined in this manner is illustrated in FIG. 2. Note that for each alloy composition, an end point at a low-temperature side of the corresponding line illustrated in FIG. 2 indicates the temperature of the liquidus at that alloy composition. Data in "Adachi M, Sato A, Hamaya S, Ohtsuka M, Fukuyama H. Containerless measurements of the liquid-state density of Ni-Al alloys for use as turvine blade materials. SN Appl Sci. 2019; 1:18-1-7." can be adopted as the temperature of the liquidus.

The temperature at which driving force $\Delta\mu = 0$ for growth of single crystal AlN at each alloy composition is the temperature at which the reaction of formula (1) is at equilibrium. Deposition of AlN proceeds when $\Delta\mu > 0$, whereas decomposition of AlN proceeds when $\Delta\mu < 0$. It can be seen from FIG. 2 that at each alloy composition, it is possible to adjust the value of the driving force $\Delta\mu$ of growth of single crystal AlN and thus to control whether deposition of AlN proceeds ($\Delta\mu > 0$) or decomposition of AlN proceeds ($\Delta\mu < 0$) by controlling the temperature of the melt 180. For example, in a case in which the melt 180 has an alloy composition of Ni-20 mol%Al, the value of $T_0$ is 1832 K. In this case, decomposition of AlN in the melt 180 proceeds at a temperature higher than 1832 K because $\Delta\mu$ is negative, whereas deposition of AlN proceeds at a temperature lower than 1832 K because $\Delta\mu$ is positive. In a case in which the nitrogen-containing gas serving as a nitrogen supply source includes $N_2$ gas, maintaining the high-temperature portion 181 of the melt 180 at a temperature higher than the temperature at which $\Delta\mu = 0$ while bringing the nitrogen-containing gas into contact with the melt causes nitrogen to dissolve in the alloy melt 180 without deposition of single crystal AlN at a contacting surface of the melt 180 and the gas, and thereby enables continuous supply of nitrogen into the melt 180. As another example, in a case in which the alloy melt 180 has an alloy composition of Ni-30 mol%Al, the value of $T_0$ is 1998 K. The composition of the alloy that forms the melt 180 is preferably selected as a composition that results in the value of $T_0$ being not lower than 1700 K and not higher than 2000 K.

It is preferable that the low-temperature portion 182 of the melt 180 is maintained at a temperature lower than the temperature at which $\Delta\mu = 0$ while holding the growth substrate 190 in this low-temperature portion 182. This results in nitrogen that has dissolved in the alloy in the high-temperature portion 181 reacting with Al in the alloy melt 180 at the surface of the growth substrate 190 that is held in the low-temperature portion 182 and enables more stable continuous growth of single crystal AlN.

The following provides a more specific description. As a result of a temperature gradient being provided in the melt 180, nitrogen is supplied into the melt 180 in the high-temperature portion 181 (T1) because $\Delta\mu < 0$ therein. Simultaneously to this nitrogen supply, supersaturation of nitrogen arises in the low-temperature portion 182 (T2) because $\Delta\mu > 0$ in the low-temperature portion 182. This more reliably enables continuous growth of single crystal AlN. Moreover, it is preferable that the temperature of the surface of the growth substrate 190 that is held in the low-temperature portion 182 is at least maintained at a temperature at which single crystal AlN of the growth substrate 190 does not decompose, and it is also preferable that straight after immersion of the AlN seed crystal or substrate for crystal growth in the melt 180 that is at a high temperature where $\Delta\mu < 0$, the surface of the single crystal AlN is cooled to a low temperature where $\Delta\mu > 0$ before the single crystal AlN serving as a starting point for crystal growth is lost. For this reason, the high-temperature portion 181 is preferably heated to a temperature that is higher than $T_0$ and lower than $T_0+30$ K. Furthermore, by heating the high-temperature portion 181 to a temperature of $T_0+30$ K or higher so as to cause dissolution of more nitrogen in the melt 180 and subsequently setting the temperature of the high-temperature portion 181 to higher than $T_0$ and lower than $T_0+30$ K prior to immersing the growth substrate 190 in the melt 180, it is possible to preserve the single crystal AlN that serves as a starting point for crystal growth while also enabling more efficient growth of single crystal AlN.

In this manner, the method of producing single crystal AlN according to the embodiment of the present disclosure makes it possible to provide a temperature gradient in the alloy melt 180 through cooling while also continuing to take in nitrogen from the high-temperature portion 181. Through appropriate selection of the type and composition of alloy, the atmosphere, the partial pressure of $N_2$, and so forth, it is possible to cheaply and continuously produce single crystal AlN at a lower temperature than with sublimation.

Note that as single crystal AlN continuously grows in the deposition step, the alloy composition of the melt 180 can change due to consumption of Al in the melt 180. For example, when the proportion of Al in the Ni-Al alloy decreases, the temperature $T_0$ for the corresponding composition decreases. Consequently, in a situation in which the temperatures of the low-temperature portion 182 and the high-temperature portion 181 remain the same as before reduction of the proportion of Al, deposition of AlN less readily occurs due to a decrease of the absolute value of $\Delta\mu$ in the low-temperature portion 182, and supply of nitrogen from the gas phase to the liquid phase increases due to an increase of the absolute value of $\Delta\mu$ in the high-temperature portion 181. Therefore, it is preferable that the temperature of the melt 180 is adjusted during the deposition step in order that the temperature of the melt 180 tracks compositional change of the melt 180. The heating conditions of the overall melt 180 may be adjusted, the temperatures of both the low-temperature portion 182 and the high-temperature portion 181 may be lowered, the temperature of just the low-temperature portion 182 may be lowered through cooling, or the temperature of the high-temperature portion 181 may be partially raised. A combination thereof is also preferable. Alternatively, the $N_2$ partial pressure of the gas phase portion may be increased during the deposition step in order to perform efficient supply of nitrogen from the gas phase to the liquid phase in the high-temperature portion 181 such that the balance of consumption of nitrogen in the melt as single crystal AlN continuously grows and supply of nitrogen into the melt is compensated.

Next, one example of a single crystal AlN growth apparatus that can be adopted in the method of producing single crystal AlN according to the embodiment of the present disclosure is described in more detail. In the following, repeated description is omitted in a case in which the final two digits of a reference sign are the same as a previously described configuration so as to simplify description. The configuration described below is merely an example of the configuration of the single crystal AlN growth apparatus, and the configuration of the single crystal AlN growth apparatus is not limited thereto.

<Single crystal AlN growth apparatus>

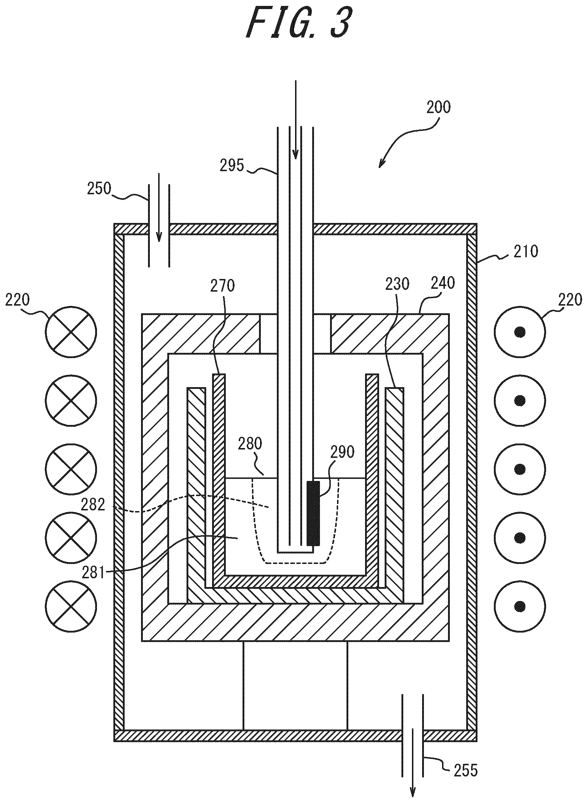

The following refers to FIG. 3. A single crystal AlN production apparatus used herein includes at least a reaction vessel 210 having an inner part that can be supplied with a nitrogen-containing gas, a crucible 270 that is housed in the inner part of the reaction vessel 210 and that can hold a melt 280 of an alloy containing Al, a heating device that can heat the melt 280 through heating of the crucible 270, and a holder 295 extending from above a liquid surface of the melt 280 to below the liquid surface. An AlN seed crystal or a substrate for crystal growth 290 is attached to the holder 295. The holder 295 includes a lifting and lowering mechanism and a cooling mechanism. The holder 295 can be brought into contact with the melt 280 using the lifting and lowering mechanism while providing a temperature gradient between the melt 280 and the AlN seed crystal or the substrate for crystal growth 290 using the cooling mechanism.

FIG. 3 illustrates one example of a single crystal AlN growth apparatus according to the embodiment of the present disclosure. The single crystal AlN growth apparatus 200 includes a reaction vessel 210, a radio frequency coil 220, a susceptor 230, a heat insulating material 240, a gas supply tube 250, and a gas discharge tube 255. The susceptor 230 is provided in an inner part of the reaction vessel 210 such as to house a crucible 270 inside thereof and cover a side surface of the housed crucible 270. Passing of current through the radio frequency coil 220 causes heating of the susceptor 230 and enables heating of the crucible 270. The crucible 270 may be any material that can hold an alloy melt 280 and examples thereof include AlN and CSZ (calcia stabilized zirconia). The heat insulating material 240 is provided in the inner part of the reaction vessel 210 such as to cover around the susceptor 230 and the crucible 270. The gas supply tube 250 is provided such that an atmosphere gas can be supplied into the inner part of the reaction vessel 210, and the gas discharge tube 255 is provided such that the atmosphere gas can be discharged from the inner part of the reaction vessel 210.

The single crystal AlN growth apparatus 200 also includes a holder 295 for a growth substrate 290. The holder 295 extends from an upper part of the reaction vessel 210 to an inner part of the crucible 270. Through lifting and lowering of the growth substrate 290, which is attached to a lower end of the holder 295, it is possible to immerse the growth substrate 290 in the melt 280 and also to lift up and recover the growth substrate 290 from the melt 280. In order to cool a portion of the melt 280, it is preferable that the holder 295 includes a cooling mechanism, and it is also preferable that the holder 295 has a double tube structure. By feeding a cooling gas or cooling liquid into an inner tube of the holder 295, it is possible to lower the temperature of the holder 295 and the surroundings thereof and to provide a temperature gradient in the melt 280. A structure other than a double tube structure can alternatively be adopted in order to cool a portion of the melt 280 and provide a temperature gradient in the melt 280. For example, a material having high heat dissipation may be used at an inner side of the holder 295, or a desired temperature gradient may be formed at a target position in the melt 280 by adjusting the shape of the crucible 270 and the position or output of the radio frequency coil 220, the heat insulating material 240, or the like.

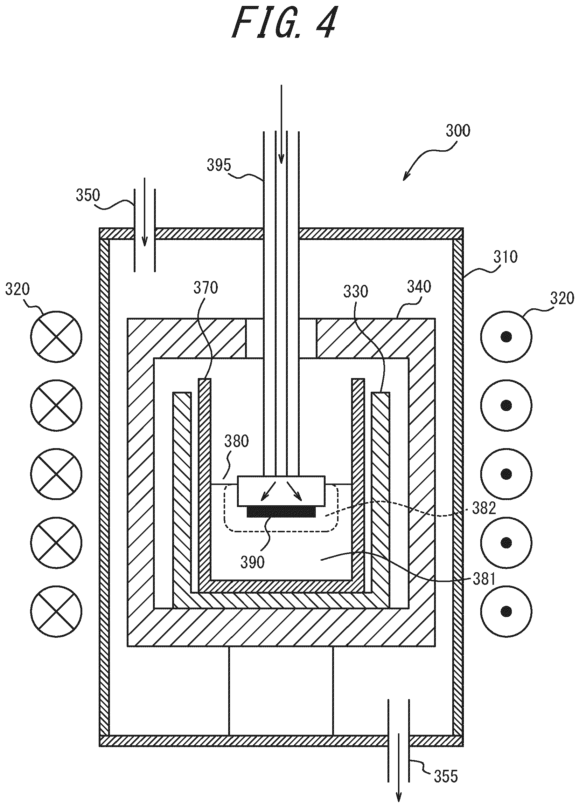

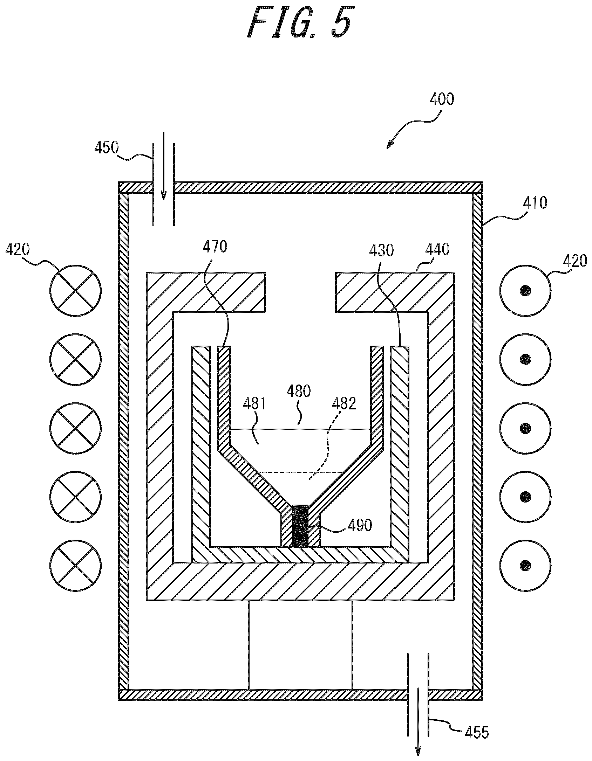

In FIG. 3, the growth substrate 290 is positioned at a side surface of the holder 295 (horizontal to an axial direction of the holder), which results in crystal growth in a direction perpendicular to the axial direction of the holder 295. The positioning of the growth substrate 290 does not need to be perpendicular to the axial direction as in FIG. 3. For example, the LEC method (Liquid Encapsulated Czochralski method) may be adopted so as to position a growth substrate 390 at the tip of a holder 395 and cause crystal growth in the same direction as an axial direction as illustrated in FIG. 4. Further alternatively, the VGF method (vertical gradient freeze method) may be adopted so as to position a growth substrate 490 at the bottom of a crucible 470 and cause crystal growth in an upper surface direction from the bottom of the crucible 470 as illustrated in FIG. 5.

<Single crystal AlN>

Single crystal AlN according to the present disclosure that has been formed on a single crystal AlN seed crystal or a substrate for crystal growth contains $8 \times 10^{16}/cm^3$ to $1 \times 10^{21}/cm^3$ of one or more of Fe, Ni, Cu, and Co as impurities, and preferably contains $1.5 \times 10^{17}/cm^3$ or more thereof. The concentration of an impurity contained in the single crystal AlN is taken to be an average value for a half-thickness range centered on the center of a region corresponding to a thickness range of the single crystal AlN in a SIMS analysis profile (i.e., a thickness range of a central 1/2 portion resulting from exclusion of both end 1/4 portions in a thickness direction of the single crystal AlN). The reason that these impurities are included is because these elements are contained in the above-described melt (alloy components other than Al include at least one element among Fe, Ni, Cu, and Co as a main component). In particular, it is preferable that the single crystal AlN contains $8 \times 10^{16}/cm^3$ to $1 \times 10^{21}/cm^3$ of Ni as an impurity, and more preferable that the single crystal AlN contains $1.5 \times 10^{17}/cm^3$ or more of Ni as an impurity.

The carbon concentration in the single crystal AlN obtained according to the present disclosure is preferably $2 \times 10^{17} cm^{-3}$ or less. A carbon concentration of $2 \times 10^{17} cm^{-3}$ or less results in high likelihood of obtaining high transmittance.

EXAMPLES

The following provides a more detailed description of the method of producing single crystal AlN according to the present disclosure using examples.

(Example 1)

First, an AlN template substrate was produced. Single crystal AlN at the surface of the AlN template substrate was formed on a C-plane sapphire substrate (M-plane direction off-angle 0.11°) of 2 inches in diameter and 430 $\mu$m in thickness by MOCVD using trimethylaluminum (TMA) and ammonia as source gases. The above was performed with a growth temperature of 1613 K and a growth pressure of 13.3 mbar, and C-plane single crystal AlN was grown for 0.5 $\mu$m on the C-plane sapphire substrate. After growth of the single crystal AlN by MOCVD, 4 hours of annealing was performed at 1873 K in a nitrogen atmosphere so as to perform dislocation reduction treatment. An X-ray rocking curve was measured for (10-12) planes of the single crystal AlN at the surface of the produced AlN template substrate, and the full width at half maximum of this X-ray rocking curve was 265 arcsec. An X-ray rocking curve for (0002) planes of the single crystal AlN that was measured in the same manner had a full width at half maximum of 49 arcsec.

Next, in an apparatus having the same structure as the single crystal AlN growth apparatus previously described with reference to FIG. 3, Ni-20 mol%Al alloy was loaded into a crucible made of sintered AlN, vacuum evacuation of an inner part of the reaction vessel was performed, and then Nz gas was supplied from the gas supply tube so as to purge the inside of the reaction vessel with $N_2$ and set an $N_2$ gas atmosphere of 1 bar in the reaction vessel. The above-described AlN template substrate including single crystal AlN having a film thickness of 0.5 $\mu$m was used as a substrate for crystal growth. This template substrate was arranged on a side surface of a double tube structure holder that included a cooling mechanism. Next, in a state in which the AlN template substrate was held by the holder formed of the double tube such as to not come into contact with the melt, current was passed through the radio frequency coil so as to heat the susceptor and thereby heat a melt of the alloy until the temperature at an interface between the crucible and the alloy melt was 1825 K. The liquidus temperature of Ni-20 mol%Al alloy is 1669 K. The upper surface temperature of a high-temperature portion of the melt at this time was 1852 K. Since the value of $T_0$ for Ni-20 mol%Al alloy is 1832 K, the temperature T1 of the high-temperature portion was $T_0$+20 K. During heating of the alloy melt, a cooling gas was caused to continuously flow in an inner tube of the holder so that AlN of the AlN template substrate did not decompose. The holder was immersed in the alloy melt while feeding Ar gas into the inner tube of the holder as a cooling gas at a flow rate of 10 L/min so as to perform cooling, and the holder was held for 7 hours such that a low-temperature portion was formed around the holder while also maintaining the temperature T1 of the high-temperature portion in order to cause deposition of AlN on the AlN template substrate. The holder was subsequently pulled out of the alloy melt and was cooled to room temperature.

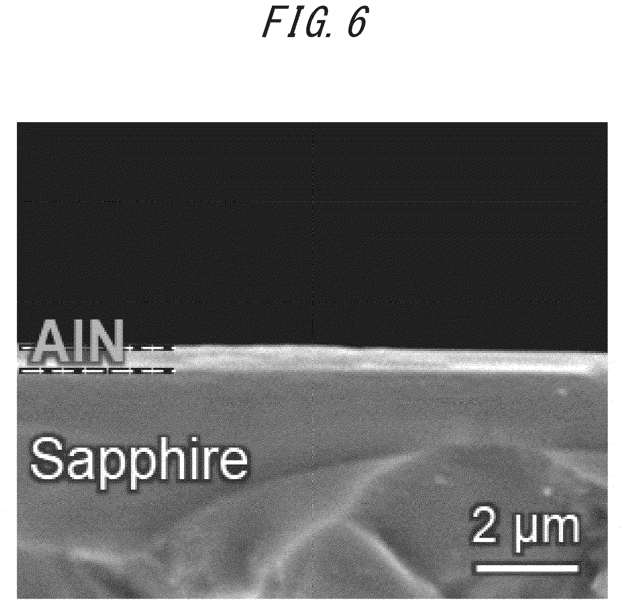

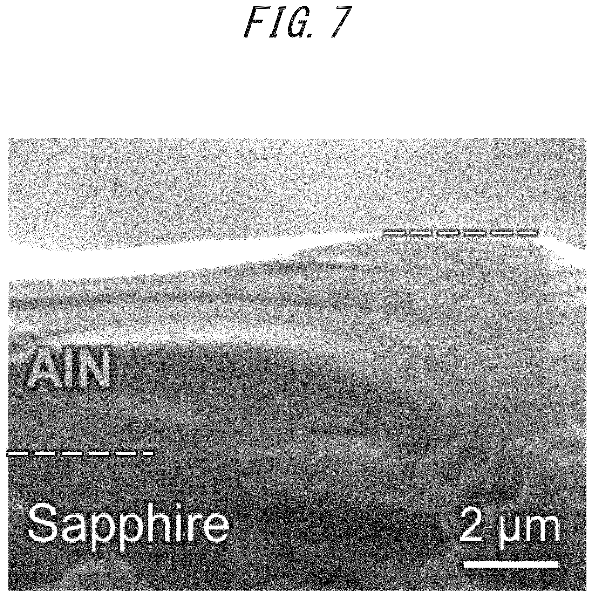

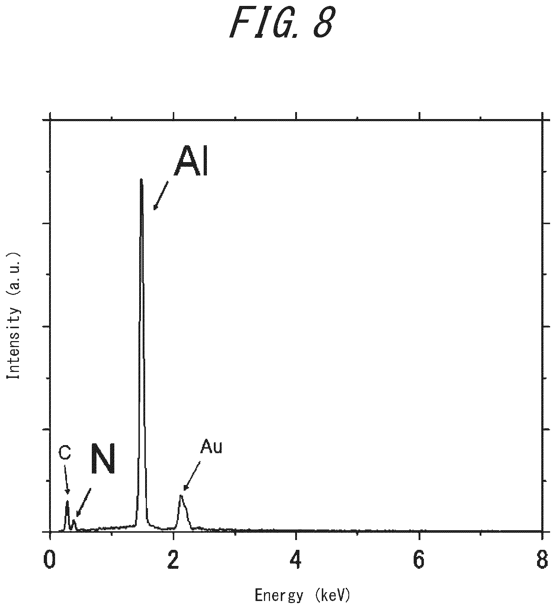

A cross-sectional SEM image of the AlN template substrate prior to AlN deposition is presented in FIG. 6, and a cross-sectional SEM image of the AlN template substrate after AlN deposition is presented in FIG. 7. Moreover, an SEM-EDX profile for the deposited crystal is presented in FIG. 8. Peaks appearing at 0.28 keV and 2.12 keV in the SEM-EDX profile in FIG. 8 respectively represent contaminant carbon in the sample and gold used as a coating agent in SEM observation and are not peaks originating from the grown (deposited and grown) crystal. The presence of a film of 4.2 $\mu$m in thickness on the sapphire was confirmed from FIG. 7, and this film was confirmed to be an AlN crystal from FIG. 8. Moreover, the grown (deposited and grown) AlN crystal was confirmed to be a single crystal as a result of confirmation of an inverse pole figure crystal orientation map (not illustrated) according to electron backscatter diffraction (EBSD) for each of ND, TD, and RD directions with respect to the grown (deposited and grown) AlN crystal in the same manner as in PTL 3. Based on the fact that the film thickness of the single crystal AlN of the AlN template substrate prior to crystal growth (deposition and growth) was 0.5 $\mu$m, it was determined that a single crystal AlN film had been grown for 3.7 $\mu$m in the present example.

(Example 2)

AlN was deposited on an AlN template substrate under the same conditions as in Example 1 with the exception that a high-temperature heating step of heating at high temperature in advance was performed before the deposition step. In the high-temperature heating step, the alloy melt was heated in advance, prior to immersion of the holder in the alloy melt, such that the temperature at the interface between the crucible and the alloy melt was 1886 K, was held thereat for 1 hour, and then cooling was performed such that the temperature at the interface between the crucible and the alloy melt was 1852 K. The upper surface temperature of a high-temperature portion of the melt was 1852 K, the temperature T1 of the high-temperature portion was $T_0$+20 K, and the temperature in the high-temperature heating step was $T_0$+54 K.

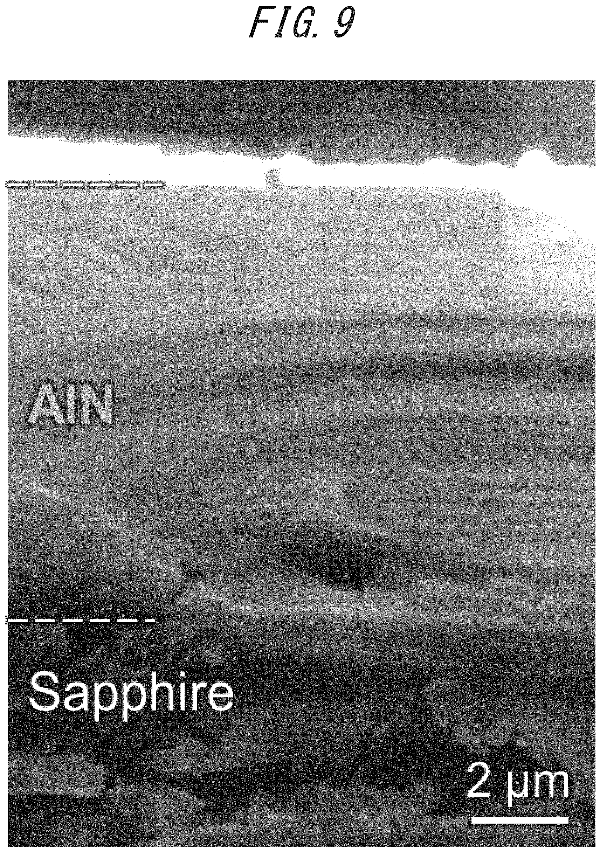

A cross-sectional SEM image of the AlN template substrate after AlN deposition is presented in FIG. 9. The presence of 8.0 $\mu$m of single crystal AlN on the sapphire was confirmed through FIG. 9. Based on the fact that the film thickness of the single crystal AlN of the AlN template substrate prior to growth (deposition and growth) was 0.5 $\mu$m, it was determined that a single crystal AlN film had been grown for 7.5 $\mu$m in the present example.

Continuous growth of the single crystal AlN on the AlN template substrate was confirmed to be greater than that in Example 1. Moreover, comparison of Example 1 and Example 2 demonstrated that the amount of single crystal AlN grown on the AlN template substrate can be increased by heating the interface between the crucible and the alloy melt to high temperature in advance, prior to immersion of the holder in the alloy melt.

(Example 3)

AlN was deposited on an AlN template substrate under the same conditions as in Example 2 with the exception that the holding time after immersion of the holder in the alloy melt was set as 1 hour. The holder was subsequently pulled out of the alloy melt and was cooled to room temperature.

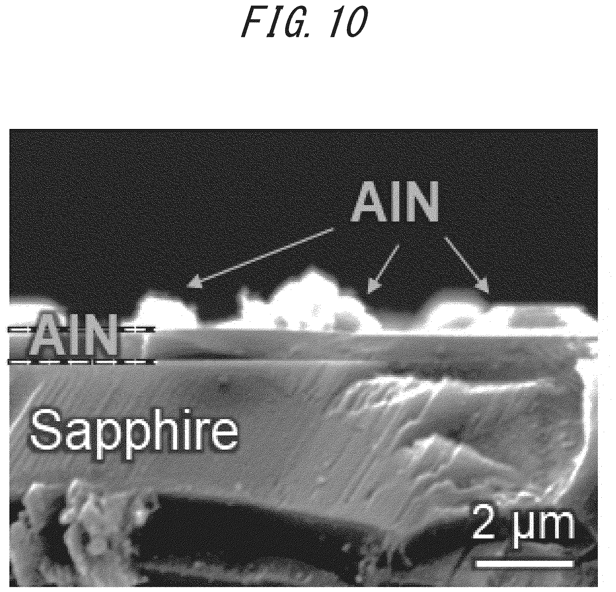

A cross-sectional SEM image of the AlN template substrate after AlN deposition is presented in FIG. 10. The presence of a single crystal AlN film of 0.7 $\mu$m in thickness on the sapphire and the presence of island-like single crystal AlN with a height of 0.8 $\mu$m above this film were confirmed through FIG. 10. Based on the fact that the film thickness of the single crystal AlN of the AlN template substrate prior to growth (deposition and growth) was 0.5 $\mu$m, it was determined that a single crystal AlN film had been grown (deposited and grown) for 0.2 $\mu$m and that island-like single crystal AlN had been grown on this film in Example 3.

It was confirmed through comparison of FIG. 9 and FIG. 10 that setting a holding time of 1 hour after immersion of the holder in the alloy melt results in the growth (deposition and growth) of island-like single crystal AlN at the surface, whereas setting the holding time as 7 hours results in only film-like single crystal AlN without island-like single crystal AlN being observed. Based on the above, it is thought that island-like single crystal AlN is deposited in an initial stage of growth (deposition and growth) and that subsequent coalescence thereof results in the deposition (growth) of film-like single crystal AlN.

(Example 4)

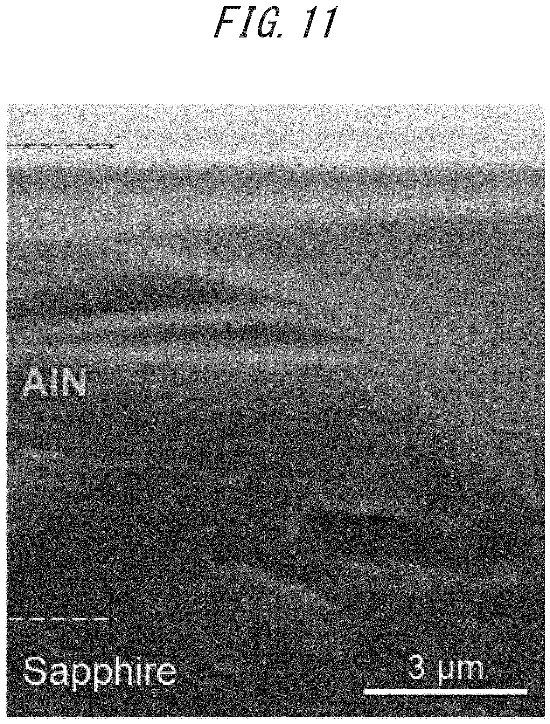

Single crystal AlN was grown (deposited and grown) on an AlN template substrate in the same way as in Example 1 with the exception that a crucible made of CSZ (ZrOz-4.5 mass%CaO) was used. A cross-sectional SEM image of the AlN template substrate after AlN deposition is presented in FIG. 11. The presence of a film of 8.8 $\mu$m in thickness on the sapphire was confirmed through FIG. 11. Based on the fact that the film thickness of the single crystal AlN of the AlN template substrate prior to single crystal growth (deposition and growth) was 0.5 $\mu$m, it was determined that a single crystal AlN film had been grown for 8.3 $\mu$m in the present example.

It was also confirmed in the results for Example 4 that single crystal AlN had been grown on the AlN template substrate in the same manner as in Examples 1 to 3. In results for Examples 1 to 3, it is thought that deposition of single crystal AlN on the AlN template substrate occurred due to nitrogen in the crucible and nitrogen in the atmosphere dissolving in the melt, whereas it was confirmed through results for Example 4 that single crystal AlN can be produced even with supply of nitrogen from only the gas phase.

In this manner, in the method of producing single crystal AlN of the embodiment of the present disclosure, heating the high-temperature portion of the alloy melt to a temperature region where $\Delta\mu$ is negative enables continuous and cheap production of single crystal AlN at a lower temperature than with sublimation so long as appropriate selections of the type and composition of alloy, the atmosphere, and the $N_2$ partial pressure are made.

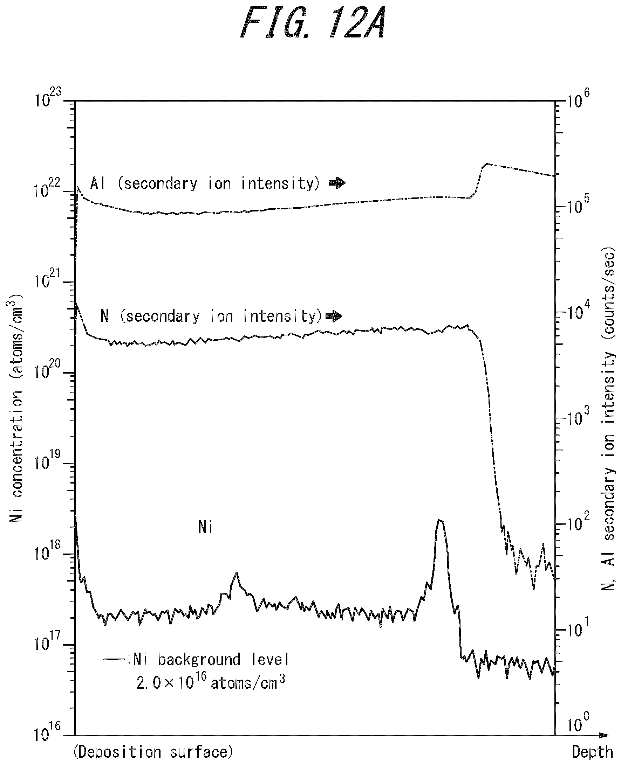

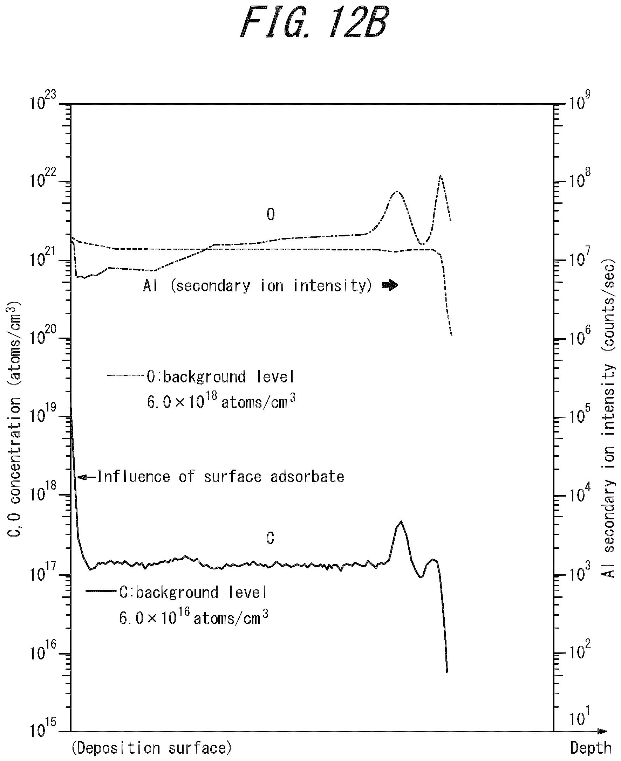

SIMS analysis results for Ni (nickel) in the single crystal AlN of Example 2 are presented in FIG. 12A, and SIMS analysis results for O (oxygen) and C (carbon) therein are presented in FIG. 12B. The SIMS analysis was performed under the following conditions. Ni analysis was performed using a SIMS measurement instrument (CAMECA IMS-7f) with a primary ion species of $O^{2+}$, a primary accelerating voltage of 8.0 kV, and a detection region diameter of 30 $\mu$m. C, O, and B analysis was performed using a SIMS measurement instrument (CAMECA IMS-6f) with a primary ion species of $Cs^+$, a primary accelerating voltage of 15.0 kV, and a detection region diameter of 30 $\mu$m. Note that quantification was performed using an AlN standard sample.

From the results of SIMS analysis illustrated in FIG. 12A, a region from a position where the Ni concentration suddenly drops to a position where N (secondary ion intensity) suddenly drops is thought to be a region indicating the single crystal AlN of the AlN template substrate that was grown by MOCVD. The Ni concentration in this region is approximately 5 $\times$ $10^{16}$ cm$^{-3}$. On the other hand, a shallow region at lower depth than the position where the Ni concentration suddenly drops is thought to be a region indicating the single crystal AlN resulting from crystal growth in Ni-20 mol%Al alloy. The Ni concentration in this region is within a range of 1.5 $\times$ $10^{17}$ cm$^{-3}$ to 3 $\times$ $10^{18}$ cm$^{-3}$. Moreover, an average value for a thickness range of a central 1/2 portion resulting from exclusion of both end 1/4 portions in a thickness direction of the single crystal AlN (hereinafter, also referred to as the "half-thickness range at the center of thickness of the single crystal AlN") was 2 $\times$ $10^{17}$ cm$^{-3}$. It was confirmed from this result that a large amount of Ni is contained as an impurity in single crystal AlN according to the present disclosure obtained through crystal growth in Ni-20 mol%Al alloy.

Moreover, in results of SIMS analysis for Ni (nickel) and Zr (zirconium) in the single crystal AlN of Example 4 in the same manner, the Ni concentration in the single crystal AlN obtained through crystal growth in Ni-20 mol%Al alloy in Example 4 had an average value of 1 $\times$ $10^{18}$ cm$^{-3}$ in a half-thickness range at the center of thickness of the single crystal AlN, and thus the Ni concentration was even greater than in Example 2. Zr was below the limit of detection.

The above demonstrates that in single crystal AlN produced by the production method according to the present disclosure, an alloy component other than Al that forms the alloy containing Al is contained as an impurity in a large quantity. Ni can be expected to display a p-type conduction effect in single crystal AlN.

The results of SIMS analysis illustrated in FIG. 12A and 12B also indicate high concentrations of both oxygen and carbon in the region that is thought to be the AlN layer of the AlN template substrate that was produced by MOCVD. The carbon concentration in the AlN layer produced by MOCVD is approximately 4 $\times$ $10^{17}$ cm$^{-3}$, whereas the carbon concentration in the single crystal AlN obtained through crystal growth in Ni-20 mol%Al alloy has an average value of 1.3 $\times$ $10^{17}$ cm$^{-3}$ in the half-thickness range at the center of thickness of the single crystal AlN.

In the case of single crystal AlN produced by sublimation or MOCVD, contamination with carbon is said to reduce transmittance in the deep-UV region. In contrast, it can be seen that with single crystal AlN according to the present disclosure that is doped with an alloy component (for example, Ni) other than Al contained in the alloy, contamination with carbon that reduces transmittance of a crystal as described above can be inhibited.

INDUSTRIAL APPLICABILITY

According to the present disclosure, it is possible to provide a method of producing single crystal AlN, single crystal AlN, and a single crystal AlN production apparatus with which single crystal AlN can be cheaply and continuously produced.

REFERENCE SIGNS LIST

| | |
|---|---|
| 100 | single crystal AlN production apparatus |
| 170 | crucible |
| 180 | melt |
| 181 | high-temperature portion |
| 182 | low-temperature portion |
| 190 | growth substrate |
| 195 | holder |

**Claims**

1. A method of producing single crystal AlN comprising:

   a melt formation step of heating and melting an alloy containing Al to form a melt of the alloy; and
   a deposition step of cooling a portion of the melt and providing a temperature gradient in the melt while causing deposition of single crystal AlN, wherein
   in the deposition step, a nitrogen-containing gas is brought into contact with a high-temperature portion of the melt and a single crystal AlN seed crystal or a substrate for crystal growth is held in a low-temperature portion of the melt so as to continue to take nitrogen into the melt in the high-temperature portion while causing deposition of the single crystal AlN on the AlN seed crystal or the substrate and continuous growth of the single crystal AlN in the low-temperature portion.

2. The method of producing single crystal AlN according to claim 1, wherein

   the nitrogen-containing gas includes $N_2$ gas, and
   when activity of Al in the melt when a reaction for formation of the single crystal AlN expressed by formula (A), shown below:

$$2Al\ (l) + N_2\ (g)\ \text{->}\ 2AlN\ (s) \qquad (A)$$

   is at equilibrium is taken to be $a^{eq}_{Al}$, an equilibrium constant of formula (A) is taken to be K, the Boltzmann constant is taken to be k, absolute temperature is taken to be T, and partial pressure of $N_2$ of the nitrogen-containing gas during deposition is taken to be pNz, and
   when a temperature at which driving force $\Delta\mu$ of growth of the single crystal AlN expressed by formula (B), shown below:
   [Math. 1]

$$\Delta\mu = kT \left( \ln P_{N2} + \ln K + \ln a^{eq\ 2}_{Al} \right) \qquad (B)$$

   has a value of 0 is taken to be $T_0$, a temperature of the high-temperature portion is set as higher than $T_0$ and a temperature of the low-temperature portion is set as not lower than a temperature of a liquidus of the alloy and lower than $T_0$.

3. The method of producing single crystal AlN according to claim 2, wherein the melt formation step includes a high-temperature heating step of heating the high-temperature portion to a temperature of $T_0 + 30$ K or higher.

4. The method of producing single crystal AlN according to claim 3, wherein the melt formation step includes a low-temperature heating step of, after the high-temperature heating step, heating the high-temperature portion to a temperature of higher than $T_0$ and lower than $T_0 + 30$ K.

5. The method of producing single crystal AlN according to any one of claims 1 to 4, wherein

   a holder that holds the single crystal AlN seed crystal or the substrate for crystal growth includes a cooling mechanism, and
the temperature gradient is provided in the melt by bringing the holder into contact with the melt in the deposition step.

6. The method of producing single crystal AlN according to any one of claims 1 to 4, wherein the substrate for crystal growth is an AlN template substrate having single crystal AlN epitaxially grown on single crystal sapphire.

7. The method of producing single crystal AlN according to claim 6, wherein the AlN template substrate is an AlN template substate having C-plane single crystal AlN epitaxially grown on C-plane single crystal sapphire, and an X-ray rocking curve for (10-12) planes of the C-plane single crystal AlN has a full width at half maximum of 300 arcsec or less.

8. The method of producing single crystal AlN according to claim 1, wherein the alloy containing Al is a Ni-Al alloy.

9. Single crystal AlN formed on a single crystal AlN seed crystal or a substrate for crystal growth and comprising $8 \times 10^{16}/cm^3$ to $1 \times 10^{21}/cm^3$ of one or more of Fe, Ni, Cu, and Co as impurities.

10. The single crystal AlN according to claim 9 formed on a single crystal AlN seed crystal or a substrate for crystal growth and comprising $8 \times 10^{16}/cm^3$ to $1 \times 10^{21}/cm^3$ of Ni as an impurity.

11. The single crystal AlN according to claim 9 or 10, having a carbon concentration of $2 \times 10^{17}$ cm$^{-3}$ or less.

12. A single crystal AlN production apparatus comprising:

a reaction vessel having an inner part that can be supplied with a nitrogen-containing gas;
a crucible that is housed in the inner part of the reaction vessel and that can hold a melt of an alloy containing Al;
a heating device that can heat the melt through heating of the crucible; and
a holder extending from above a liquid surface of the melt to below the liquid surface of the melt, wherein
an AlN seed crystal or a substrate for crystal growth is attached to the holder,
the holder includes a lifting and lowering mechanism and a cooling mechanism, and
the holder can be brought into contact with the melt using the lifting and lowering mechanism while providing a temperature gradient between the melt and the AlN seed crystal or the substrate for crystal growth using the cooling mechanism.

# FIG. 1

## FIG. 2

# FIG. 3

# FIG. 4

# FIG. 5

## FIG. 6

## FIG. 7

# FIG. 8

## FIG. 9

*FIG. 10*

## FIG. 11

# FIG. 12A

# FIG. 12B

## INTERNATIONAL SEARCH REPORT

| International application No. |
| --- |
| **PCT/JP2023/006081** |

### A. CLASSIFICATION OF SUBJECT MATTER

**C30B 29/38**(2006.01)i; **C30B 17/00**(2006.01)i; **C30B 19/02**(2006.01)i
FI:    C30B29/38 C; C30B17/00; C30B19/02

According to International Patent Classification (IPC) or to both national classification and IPC

### B. FIELDS SEARCHED

Minimum documentation searched (classification system followed by classification symbols)

C30B29/38; C30B17/00; C30B19/02

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JST7580/JSTChina (JDreamIII)

### C. DOCUMENTS CONSIDERED TO BE RELEVANT

| Category* | Citation of document, with indication, where appropriate, of the relevant passages | Relevant to claim No. |
| --- | --- | --- |
| X | JP 2015-189651 A (SUMITOMO METAL MINING CO., LTD.) 02 November 2015 (2015-11-02)<br>    claim 1, paragraph [0019], fig. 1 | 1, 5, 12 |
| A | JP 2016-155711 A (SUMITOMO METAL MINING CO., LTD.) 01 September 2016 (2016-09-01)<br>    claim 1 | 1-12 |
| A | JP 2019-194133 A (TOHOKU UNIVERSITY) 07 November 2019 (2019-11-07)<br>    claims 1-8 | 1-12 |
| A | JP 2015-006975 A (SUMITOMO METAL MINING CO., LTD.) 15 January 2015 (2015-01-15)<br>    claims 1-9 | 1-12 |

☐ Further documents are listed in the continuation of Box C.          ☑ See patent family annex.

| | |
| --- | --- |
| *    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **14 April 2023** | **09 May 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

| | International application No. |
|---|---|
| | **PCT/JP2023/006081** |

| Patent document<br>cited in search report | | | Publication date<br>(day/month/year) | Patent family member(s) | Publication date<br>(day/month/year) |
|---|---|---|---|---|---|
| JP | 2015-189651 | A | 02 November 2015 | (Family: none) | |
| JP | 2016-155711 | A | 01 September 2016 | (Family: none) | |
| JP | 2019-194133 | A | 07 November 2019 | (Family: none) | |
| JP | 2015-006975 | A | 15 January 2015 | (Family: none) | |

Form PCT/ISA/210 (patent family annex) (January 2015)

28

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004224600 A
- JP H11189498 A
- JP 2019194133 A

### Non-patent literature cited in the description

- Desai PD. Thermodynamic properties of selected binary aluminum alloy systems. *J Phys Chem Ref data.*, 1987, vol. 16, 109-24
- **ADACHI M ; SATO A ; HAMAYA S ; OHTSUKA M ; FUKUYAMA H**. Containerless measurements of the liquid-state density of Ni-Al alloys for use as turvine blade materials. *SN Appl Sci.*, 2019, vol. 1